# EUROPÄISCHE PATENTANMELDUNG

(11) **EP 2 124 261 A1**
(43) Veröffentlichungstag der Anmeldung: **25.11.2009**
(21) Anmeldenummer: 08405143.2
(22) Anmeldetag: 23.05.2008
(51) Int. Cl.: H01L 31/048

(54) **Rückseitenlaminat-Struktur für ein Fotovoltaik-Modul**

(71) Anmelder: Alcan Technology & Management Ltd., 8212 Neuhausen am Rheinfall (CH)
(72) Erfinder: Lohwasser, Wolfgang, 78262 Gailingen (DE); Jannon, Bertrand, 78343 Horn (DE)

(57) **Zusammenfassung**

Ein Fotovoltaik-Modul in Form eines Laminates (10) weist eine Kernschicht aus einem in einer Einbettmasse (20, 24) angeordneten Solarzellensystem (22) mit einer optisch aktiven Seite und einer Rückseite auf. Auf der optisch aktiven Seite des Solarzellensystem (22) ist eine erste Einkapselungsschicht (E1) und auf der Rückseite des Solarzellensystem (22) eine zweite Einkapselungsschicht (E2) angeordnet. Die Einbettmasse (20, 24) verbindet das Solarzellensystem (20) mit der ersten und der zweiten Einkapselungsschicht (E1, E2), und das Laminat (10) weist eine auf der der Rückseite des Solarzellensystems (22) abgewandten Seite der zweiten Einkapselungsschicht (E2) angeordnete Barriereschicht (14) gegen den Durchtritt von Wasserdampf in Form einer anorganischen Oxid- oder Nitridschicht auf.

## Beschreibung

Die Erfindung betrifft ein Fotovoltaik-Modul in Form eines Laminates, mit einer Kernschicht aus einem in einer Einbettmasse angeordneten Solarzellensystem mit einer optisch aktiven Seite und einer Rückseite, einer auf der optisch aktiven Seite des Solarzellensystem angeordneten ersten Einkapselungsschicht und einer auf der Rückseite des Solarzellensystem angeordneten zweiten Einkapselungsschicht, wobei die Einbettmasse das Solarzellensystem mit der ersten und der zweiten Einkapselungsschicht verbindet und das Laminat eine der Rückseite des Solarzellensystem zugewandte Barriereschicht gegen den Durchtritt von Wasserdampf in Form einer anorganischen Oxid- oder Nitridschicht aufweist.

Fotovoltaik-Module oder Solarzellen-Module dienen der Erzeugung elektrischer Energie aus Sonnenlicht. Die Energieerzeugung erfolgt dabei durch das Solarzellensystem, welches vorzugsweise aus Zellen aus amorphem oder kristallinem Silizium gebildet ist. Ein derartiges Solarzellensystem ist jedoch mechanisch nur wenig belastbar und muss beidseitig von einer Einkapselungsschicht umhüllt sein. Bekannte Einkapselungsschichten bestehen aus Glas oder aus ein- oder mehrschichtigen Kunststofffolien bzw. Kunststofffolienverbunden.

Gewöhnliche Solarzellenmodule weisen heute eine Glasscheibe als starren Träger für das ganze Modul und als transparenten Schutz für die Solarzellen auf. Die Solarzellen sind üblicherweise in einer Einbettmasse aus EthylenVinylacetat (EVA) eingebettet, wobei das EVA die Zellen auf der optisch aktiven Seite mit der Glasscheibe und auf der Rückseite mit einem aus Folien aus Polyethylenterephthalat (PET) und Polyvinylfluorid (PVF) aufgebauten Rückseitenlaminat verbindet.

Das Rückseitenlaminat soll im wesentlichen die Struktur mechanisch schützen und vor allem über die gesamte Lebensdauer eines Moduls von bis zu 30 Jahren eine ausreichend hohe elektrische Isolation sicherstellen. Die Systemspannungen in einer Modulinstallation können dabei bis zu 400 V betragen.

Das Rückseitenlaminat muss daher als Isolationsschicht unter Bewitterung stabil sein. Ausserdem muss das Laminat die während des Herstellungsprozesses des Solarmoduls auftretenden hohen Temperaturen, die zum Aufschmelzen und anschliessenden Quervernetzen der EVA-Komponente notwendig sind, schadlos überstehen. Wegen der geforderten hohen Temperaturbeständigkeit kommen daher als Materialien für das Rückseitenlaminat nur technische Polymere wie PET oder PC (Polycarbonat) zum Einsatz. Am kostengünstigsten ist dabei PET. Ein wesentlicher Nachteil von PET ist jedoch die Eigenschaft, bei hoher Feuchte und erhöhter Temperatur zu hydrolysieren und damit langsam zu verspröden. Bei zu hohem Versprödungsgrad kann sich PET vom Modul ablösen, so dass die elektrische Isolationswirkung der PET-Folie nicht mehr gewährleistet ist.

Üblicherweise wird das Versprödungsproblem heute dadurch gelöst, dass das PET zwischen zwei PVF-Folien eingebettet wird. Dadurch ist das PET nicht mehr direkt der Luftfeuchtigkeit ausgesetzt und der Hydrolyseprozess des PET ist ausreichend verzögert.

PVF ist sehr teuer. Zudem ist auch seine Entsorgung als Fluorpolymer problematisch.

Ein Fotovoltaik-Modul der eingangs genannten Art ist aus EP-B-1 018 166 bekannt. Die als Barriereschicht gegen den Durchtritt von Wasserdampf eingesetzte anorganische Oxidschicht ist hierbei auf der dem Solarzellensystem zugewandten Seite einer als Einkapselungsschicht verwendeten Kunststofffolie bzw. eines Kunststofffolienverbundes angeordnet. Die durch die Kunststofffolie bzw. den Kunststofffolienverbund gebildete elektrische Isolationsschicht ist demzufolge der direkten Bewitterung und damit der Feuchteeinwirkung ausgesetzt.

Der Erfindung liegt die Aufgabe zugrunde, ein für die Einkapselung der Rückseite von Solarmodulen geeignetes Folienlaminat vorzuschlagen, welches unter Feuchteeinwirkung stabil bleibt.

Zur erfindungsgemässen Lösung der Aufgabe führt, dass die Barriereschicht auf der der Rückseite des Solarzellensystems abgewandten Seite der zweiten Einkapselungsschicht angeordnet und gegen mechanische Beschädigung mit einer Schutzschicht aus Kunststoff versehen ist.

Die Schutzschicht kann eine Folie aus Kunststoff mit einer Dicke von 4 bis 50 µm sein.

Die Schutzschicht ist z.B. eine Folie aus PET, die optional mit einem UV-Blocker stabilisiert oder mit einem UV-absorbierenden Pigment, insbesondere mit Russ oder mit TiO₂, eingefärbt sein kann.

Die Schutzschicht kann auch eine Folie aus PEN sein. PEN ist selber UV-stabil/absorbierend und hydrolysebeständig.

Die Schutzschicht kann auch ein Lack, insbesondere ein 2-Komponenten Epoxydharzsystem, sein, wobei der Lack optional mit einem UV-absorbierenden Pigment, insbesondere mit Russ oder mit TiO₂, eingefärbt sein kann.

Die auf der Rückseite des Solarzellensystems angeordnete zweite Einkapselungsschicht ist bevorzugt eine ein- oder mehrschichtige Folie aus PET und/oder PC und hat die Funktion einer elektrischen Isolationsschicht.

Auf der dem Solarzellensystem zugewandten Seite der zweiten Einkapselungsschicht kann eine weitere, mit einem UV-Blocker stabilisierte oder mit einem UV-absorbierenden Pigment, insbesondere mit Russ oder mit TiO₂, eingefärbte Folie aus PET angeordnet sein.

Anstelle einer separaten PET-Folie mit UV-absorbierenden Eigenschaften kann die zweite Einkapselungsschicht (E2) mit einem UV-Blocker stabilisiert oder mit einem UV-absorbierenden Pigment, insbesondere mit Russ oder mit TiO₂, eingefärbt sein.

Die Barriereschicht gegen Wasserdampf kann auf der Schutzschicht oder auf der zweiten Einkapselungsschicht angeordnet und mittels einer Klebstoffschicht mit der jeweils anderen Schicht verbunden sein. Vorteilhafterweise wird die zu beschichtende Folie mittels Plasmavorbehandlung vorgereinigt und/oder aktiviert.

Die Wasserdampf-Barriereschicht ist bevorzugt eine durch Verdampfen mittels Elektronenstrahlung im Vakuum auf die Schutzschicht oder auf die zweite Einkapselungsschicht aufgebrachte anorganische Oxidschicht, insbesondere eine Schicht aus SiOₓ, wobei x einen Wert von 1,2 bis 1,8, vorzugsweise 1,3 bis 1,7, bedeutet. Die Dicke der Barriereschicht liegt bevorzugt zwischen etwa 30 und 200 nm.

Erfindungswesentlich ist, dass die Wasserdampf-Barriereschicht auf der vom Solarzellensystem abgewandten Seite der zweiten Einkapselungsschicht bzw. der elektrischen Isolierschicht angeordnet ist. Durch die auf der Aussenseite der zweiten Einkapselungsschicht liegende Barriereschicht wird die Isolationsschicht, die ein- oder mehrschichtig aufgebaut sein kann, vor Feuchtigkeit und damit vor Hydrolyse geschützt. Mit der erfindungsgemässen Anordnung der Wasserdampfbarriere kann auf den Einsatz von teuren Fluorpolymeren verzichtet werden.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt schematisch in
- Fig. 1: ein Funktionsmodell eines Fotovoltaik-Moduls mit erfindungsgemässem Aufbau eines Rückseitenlaminates;
- Fig. 2: ein erstes Ausführungsbeispiel des Rückseitenlaminates von Fig.1;
- Fig. 3: ein zweites Ausführungsbeispiel des Rückseitenlaminates von Fig.1;
- Fig. 4: ein drittes Ausführungsbeispiel des Rückseitenlaminates von Fig.1.

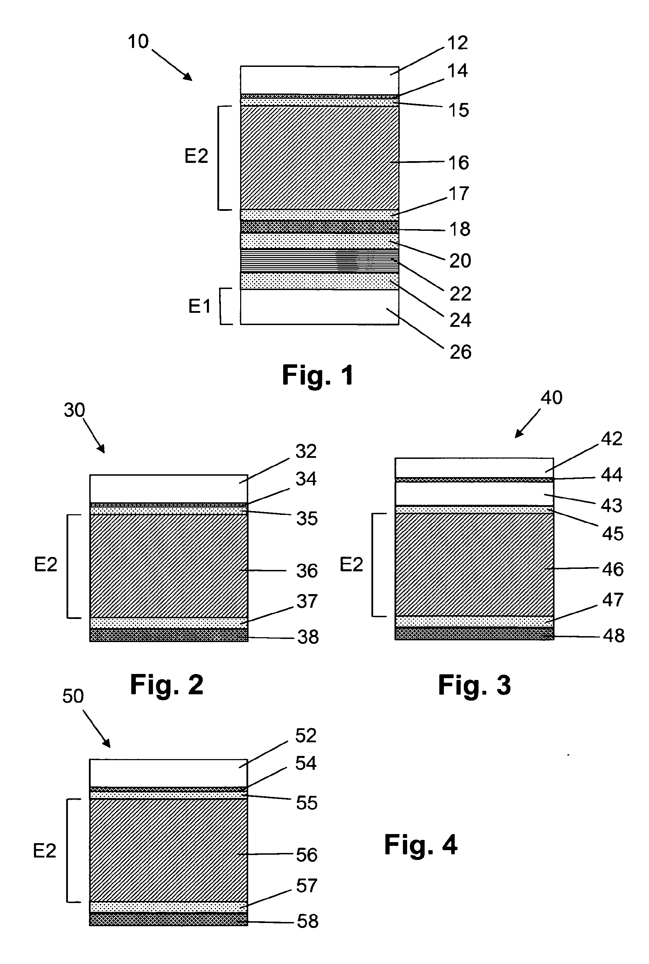

Ein in Fig. 1 dargestelltes Funktionsmodell eines Fotovoltaik-Moduls 10 zeigt folgenden Aufbau:
- 12: Schutzschicht
- 14: Barriereschicht gegen Wasserdampf
- 15: Klebstoffschicht
- 16: zweite Einkapselungsschicht E2, z.B. aus PET und/oder PC
- 17: Klebstoffschicht
- 18: Barriereschicht gegen UV-Strahlung, optional
- 20: Einbettmasse
- 22: Solarzellensystem
- 24: Einbettmasse
- 26: erste Einkapselungsschicht E1, z.B. aus Glas

Die zweite Einkapselungsschicht 16 (E2) ist eine elektrische Isolationsschicht. Sie kann eine ein- oder mehrschichtige Folie sein. Die Schutzschicht 12, die Barriereschicht 14 gegen Wasserdampf, die zweite Einkapselungsschicht 16 (E2) und die optionale UV-Barriereschicht 18 bilden zusammen das so genannte Rückseitenlaminat.

Ein in Fig. 2 dargestelltes erstes Rückseitenlaminat 30 zeigt folgenden Aufbau:
- 32: PEN-Folie, 12 µm dick, Schutzschicht mit UV-Schutz
- 34: SiO_{1.5},100 nm dick, Wasserdampf-Barriere
- 35: Klebstoffschicht
- 36: PET-Folie, 175 µm dick, Isolationsschicht
- 37: Klebstoffschicht
- 38: PET_{weiss} (mit TiO₂ eingefärbt), UV-Barriere

Die Barriereschicht 34 ist auf der Rückseite der Schutzschicht 32 abgeschieden.

Ein in Fig. 3 dargestelltes zweites Rückseitenlaminat 40 zeigt folgenden Aufbau:
- 42: Lackschicht, pigmentiert (z.B. Russ), Schutzschicht mit UV-Schutz
- 44: SiO_{1.5}, 100 nm dick, Wasserdampf-Barriere
- 43: PET-Folie, 12 µm dick, Zwischenfolie
- 45: Klebstoffschicht
- 46: PET-Folie, 175 µm dick, Isolationsschicht
- 47: Klebstoffschicht
- 48: PET_{weiss} (mit TiO₂ eingefärbt), UV-Barriere

Die Barriereschicht 44 ist auf der als Zwischenfolie eingesetzten PET-Folie 43 abgeschieden.

Ein in Fig. 4 dargestelltes drittes Rückseitenlaminat 50 zeigt folgenden Aufbau:
- 52: PET Hostaphan^{®} RUVK, Schutzschicht mit UV-Schutz
- 54: SiO_{1.5}, 100 nm dick, Wasserdampf-Barriere
- 55: Klebstoffschicht
- 56: PET-Folie, 175 µm dick, Isolationsschicht
- 57: Klebstoffschicht
- 58: PET_{weiss} (mit TiO₂ eingefärbt), UV-Barriere

Die Barriereschicht 54 ist auf der Rückseite der Schutzschicht 52 abgeschieden.

## Patentansprüche

1. Fotovoltaik-Modul in Form eines Laminates (10), mit einer Kernschicht aus einem in einer Einbettmasse (22, 24) angeordneten Solarzellensystem (22) mit einer optisch aktiven Seite und einer Rückseite, einer auf der optisch aktiven Seite des Solarzellensystem (22) angeordneten ersten Einkapselungsschicht (E1) und einer auf der Rückseite des Solarzellensystem (22) angeordneten zweiten Einkapselungsschicht (E2), wobei die Einbettmasse (20, 24) das Solarzellensystem (22) mit der ersten und der zweiten Einkapselungsschicht (E1, E2) verbindet und das Laminat (10) eine der Rückseite des Solarzellensystem (22) zugewandte Barriereschicht (14, 34, 44, 54) gegen den Durchtritt von Wasserdampf in Form einer anorganischen Oxid- oder Nitridschicht aufweist,
**dadurch gekennzeichnet, dass**
die Barriereschicht (14, 34, 44, 54) auf der der Rückseite des Solarzellensystems (22) abgewandten Seite der zweiten Einkapselungsschicht (E2) angeordnet und gegen mechanische Beschädigung mit einer Schutzschicht (12, 32, 42, 52) aus Kunststoff versehen ist.

2. Fotovoltaik-Modul nach Anspruch 1, **dadurch gekennzeichnet, dass** die Schutzschicht (12, 32, 42, 52) eine Folie aus Kunststoff mit einer Dicke von 4 bis 50 µm ist.

3. Fotovoltaik-Modul nach Anspruch 1 oder 2, **dadurch gekennzeichnet, dass** die Schutzschicht (54) eine Folie aus PET ist.

4. Fotovoltaik-Modul nach Anspruch 3, **dadurch gekennzeichnet, dass** die Schutzschicht (54) aus PET mit einem UV-Blocker stabilisiert oder mit einem UV-absorbierenden Pigment, insbesondere mit Russ oder mit TiO₂, eingefärbt ist.

5. Fotovoltaik-Modul nach Anspruch 1 oder 2, **dadurch gekennzeichnet, dass** die Schutzschicht (34) eine Folie aus PEN ist.

6. Fotovoltaik-Modul nach Anspruch 1 oder 2, **dadurch gekennzeichnet, dass** die Schutzschicht (44) ein Lack, insbesondere ein 2-Komponenten Epoxydharzsystem, ist.

7. Fotovoltaik-Modul nach Anspruch 6, **dadurch gekennzeichnet, dass** der Lack mit einem UV-absorbierenden Pigment, insbesondere mit Russ oder mit TiO₂, eingefärbt ist.

8. Fotovoltaik-Modul nach einem der Ansprüche 1 bis 7, **dadurch gekennzeichnet, dass** die auf der Rückseite des Solarzellensystems (22) angeordnete zweite Einkapselungsschicht (E2) eine ein- oder mehrschichtige Folie aus PET und/oder PC ist.

9. Fotovoltaik-Modul nach Anspruch 8, **dadurch gekennzeichnet, dass** auf der dem Solarzellensystem (22) zugewandten Seite der zweiten Einkapselungsschicht (E2) eine mit einem UV-Blocker stabilisierte oder mit einem UV-absorbierenden Pigment, insbesondere mit Russ oder mit TiO₂, eingefärbte Folie aus PET angeordnet ist.

10. Fotovoltaik-Modul nach Anspruch 8, **dadurch gekennzeichnet, dass** die zweite Einkapselungsschicht (E2) mit einem UV-Blocker stabilisiert oder mit einem UV-absorbierenden Pigment, insbesondere mit Russ oder mit TiO₂, eingefärbt ist.

11. Fotovoltaik-Modul nach einem der Ansprüche 1 bis 10, **dadurch gekennzeichnet, dass** die Barriereschicht (14, 34, 44, 54) gegen Wasserdampf auf der Schutzschicht (12, 32, 42, 52) oder auf der zweiten Einkapselungsschicht (E2) angeordnet und mittels einer Klebstoffschicht mit der jeweils anderen Schicht verbunden ist.

12. Fotovoltaik-Modul nach einem der Ansprüche 1 bis 10, **dadurch gekennzeichnet, dass** die Barriereschicht (14, 34, 44, 54) eine durch Verdampfen mittels Elektronenstrahlung im Vakuum auf die Schutzschicht (12, 32, 42, 52) oder auf die zweite Einkapselungsschicht (E2) aufgebrachte anorganische Oxidschicht, insbesondere eine Schicht aus SiOₓ, ist, wobei x einen Wert von 1,2 bis 1,8, vorzugsweise 1,3 bis 1,7, bedeutet.
